# EUROPEAN PATENT SPECIFICATION

(11) **EP 4 768 427 B1**
(45) Date of publication and mention of the grant of the patent: **14.10.2026**
(21) Application number: 25217105.3
(22) Date of filing: 19.11.2025
(51) Int. Cl.: B81C 1/00

(54) **METHOD FOR MANUFACTURING A MICRO-ELECTROMECHANICAL-SYSTEM WITH A DIAMOND BEAM STRUCTURE**
VERFAHREN ZUR HERSTELLUNG EINES MIKROELEKTROMECHANISCHEN SYSTEMS MIT EINER DIAMANT-BALKENSTRUKTUR
PROCÉDÉ DE FABRICATION D'UN SYSTÈME MICRO-ÉLECTROMÉCANIQUE À STRUCTURE DE POUTRE EN DIAMANT

(30) Priority: 31.12.2024 LU 509592
(43) Date of publication of application: 01.07.2026
(73) Proprietor: Fyzikální ústav AV CR, v. v. i., 18200 Praha 8 (CZ)
(72) Inventor: Kromka, Alexander, Praha (CZ); Potocky, Stepan, Praha (CZ); Szabo, Ondrej, Praha (CZ); Vanko, Gabriel, Praha (CZ)
(74) Representative: Bauer, Karel

(56) References cited:
- US-A- 5 729 074
- ZEHETNER J ET AL: "Diamond cantilevers for MEMS sensor applications fabricated by laser ablation and optimized etching techniques", 2022 14TH INTERNATIONAL CONFERENCE ON ADVANCED SEMICONDUCTOR DEVICES AND MICROSYSTEMS (ASDAM), IEEE, 23 October 2022 (2022-10-23), pages 1 - 4, XP034241833, ISBN: 978-1-6654-6977-7, [retrieved on 20221207], DOI: 10.1109/ASDAM55965.2022.9966776
- ERTL S ET AL: "Surface micromachined diamond microswitch", DIAMOND AND RELATED MATERIALS, ELSEVIER SCIENCE PUBLISHERS , AMSTERDAM, NL, vol. 9, no. 3, 15 June 2017 (2017-06-15), pages 970 - 974, XP085073235, ISSN: 0925-9635, DOI: 10.1016/S0925-9635(99)00292-7

## Description

### Technical field

The present invention relates to a method of manufacturing a micro-electrical-mechanical-system with a beam structure. The present invention particularly relates to a method of manufacturing such a system using a combination of chemical etching and laser evaporation.

### State of the art

Known for its exceptional optical transparency, diamond is a material that is difficult to machine mechanically. However, due to its built-in atomic imperfections and impurities, combined with its increased peak power density and intense thermal effects, diamond can be machined using a laser.

In previous studies, various laser sources with different wavelengths, from ultraviolet to infrared, and with different pulse lengths, from nanoseconds to femtoseconds , have been tested for diamond ablation . Research has shown that it is necessary to exceed a certain ablation threshold for effective diamond ablation. The ablation process with nanosecond or longer laser pulses involves a solid-state phase transformation, melting and/or vaporization of the target material due to thermal activation, while femtosecond laser ablation is the process of removing material by directly breaking the molecular bonds of the target material.

Microelectromechanical systems (MEMS) are a technology that integrates mechanical elements and electronics on a common silicon chip platform. This technology enables the production of miniature devices capable of performing a variety of tasks, from measuring physical quantities to manipulating micro- and nanostructures .

One of the key advantages of MEMS is their ability to combine electronic and mechanical functions in a very small area, allowing the creation of sophisticated systems that are compact, lightweight, and energy-efficient.

Despite its many advantages, MEMS technology faces several challenges, particularly in the areas of manufacturing and reliability. The manufacturing process of MEMS devices is complex and often requires precise control over microscopic structures and materials. Precise control of MEMS is particularly difficult when manufacturing MEMS with a beam structure.

US2012329255A1 discloses technologies related to microelectromechanical systems (MEMS) and more specifically MEMS with a beam structure. The invention describes a method of manufacturing MEMS, which includes forming an electrode on a substrate and forming a structural layer around the periphery of the electrode. This layer is then released, thereby forming a beam, i.e. a beam structure, connected to the substrate. The formation of the structural layer may include laser recrystallization or in order to change the crystallinity through the thickness of the structural element. Fig. 3A of this document shows an isometric view of a cantilever beam deposited out of plane, while Figs. 3B and 3C show a plan and cross-sectional view of this beam. In one embodiment, a conventional deposition method, such as CVD or PECVD, is used to deposit the individual layers.

A disadvantage of the current state of the art is the lack of efficient fabrication of beam MEMS structures that would be usable in extreme conditions using materials with a wide band gap that can compete with well-developed and widely used silicon-based MEMS. The document US 5 729 074 A discloses a method having the following steps. Molybdenum or silicon nitride is deposited to form a sacrificial layer. Then, predetermined regions of the sacrificial layer not covered with mask material are removed by reactive ion etching. Next, a p-type diamond layer is formed in a CVD process over the surface of the sacrificial layer. Then, the surface region of the p-type diamond layer not covered with mask material is removed by reactive ion etching, thereby forming a beam. Subsequently, the wafer or chip is immersed in a HF wet etchant to remove the sacrificial layer.

### Summary of the invention

The present invention provides a method for manufacturing a micro-electrical-mechanical-system.

The method of manufacturing a micro-electrical-mechanical-system with a beam structure comprises the following steps. In the first step, a substrate is provided. In a preferred embodiment, the substrate material may be selected from the following: silicon - Si, silicon carbide SiC , aluminum nitride AlN , glass, sapphire. Subsequently, a sacrificial layer of silicon dioxide or silicon nitride is deposited on the substrate. In the next step, at least a portion of the sacrificial layer is removed by cutting or etching using laser-assisted machining, or wet etching, or dry etching. In a preferred embodiment, however, an etching step is selected because it provides better defined edges of the beam structure, whereby the MEMS beam structure then has sharper edges. Subsequently, a diamond layer is deposited on the sacrificial layer and, simultaneously, in the place where the sacrificial layer was removed in order to form a part for supporting the beam structure. The diamond layer is deposited to such a height that the diamond layer on the sacrificial layer and the part for supporting the beam structure are connected. The method according to the invention comprises the step of further depositing a further diamond layer at the location of the removed portion for mechanical strengthening the part supporting the beam structure. In the next step, another functional layer is deposited, preferably AlN , or SiC, or amorphous silicon according to the desired piezoelectric properties or electrical conductivity.

This is followed by removing at least a portion of the diamond layer deposited on the sacrificial layer, wherein the removal of the portion of the diamond layer is performed by direct laser removal through the entire thickness of the diamond down to the sacrificial layer. In the last step, the sacrificial layer is removed, in particular under the beam, in its entire thickness by laser-assisted machining, or wet etching, or dry etching in the beam lines down to the substrate, thereby forming a freely hanging embedded beam. Between the steps of applying the sacrificial layer and the application of the diamond layer an electrically conductive layer is applied to serve as an electrode of the beam structure. Examples of electrically conductive layers include Au, Ir, Pt, Cu, Al, doped Si. The electrically conductive layer can serve as a bottom electrode for electromechanical excitation of the beam (using an electrical signal).

The advantage of this manufacturing method is to ensure an ideal anchoring location of the beam. One of the key problems in the manufacture of MEMS beam structures is the geometrically undefined undercutting at the anchoring location, which causes deviations in the dimensions of the " microbeam " according to the present invention. The anchoring location is usually not taken into account in the design of various structures of embedded beams and in numerical analyses for dimensions typical in the MEMS field, in order to keep the numerical analysis within time-consuming limits. However, this deviation from the ideal anchoring can cause serious discrepancies, especially in applications where high accuracy is required. The losses at the anchoring location are caused by the bonding, i.e.. connection, of the microbeam (in general any MEMS structure) with the substrate material and are usually proportional to the size of the microbeam and the stiffness of the anchoring.

In a preferred embodiment, the sacrificial layer is deposited to a thickness of 150 nm to 200 µm.

In another preferred embodiment, the diamond layer is deposited on the sacrificial layer using microwave plasma assisted chemical vapor deposition.

In another preferred embodiment, the diamond layer is deposited on the sacrificial layer using filament -assisted chemical vapor deposition.

In another preferred embodiment, the step of removing the sacrificial layer comprises wet etching using a hydrofluoric acid solution, or reactive ion etching in a gas mixture of fluorine and argon.

In another preferred embodiment, the sacrificial layer is only partially removed.

### Brief description of drawings

Fig. 1 represents the first step of the method according to the invention, which schematically illustrates the deposition of a sacrificial layer on a substrate.
Fig. 2 represents a further step of the method according to the invention, which schematically illustrates the removal of at least a part of the sacrificial layer down to the substrate for supporting the beam structure.
Fig. 3 represents a further step of the method according to the invention, which schematically shows the application of a diamond layer on the sacrificial layer and in place of the removed sacrificial layer formed to support the beam structure.
Fig. 4 represents a further step of the method according to the invention, in which the removal of at least a part of the diamond layer onto a sacrificial layer is schematically illustrated .
Fig. 5 shows a further step of the method according to the invention, in which the removal of the sacrificial layer is schematically illustrated. The figure shows a preferred embodiment in which at least a part of the sacrificial layer is retained.
Fig. 6 presents a schematic representation of a MEMS with a beam structure from the front view.

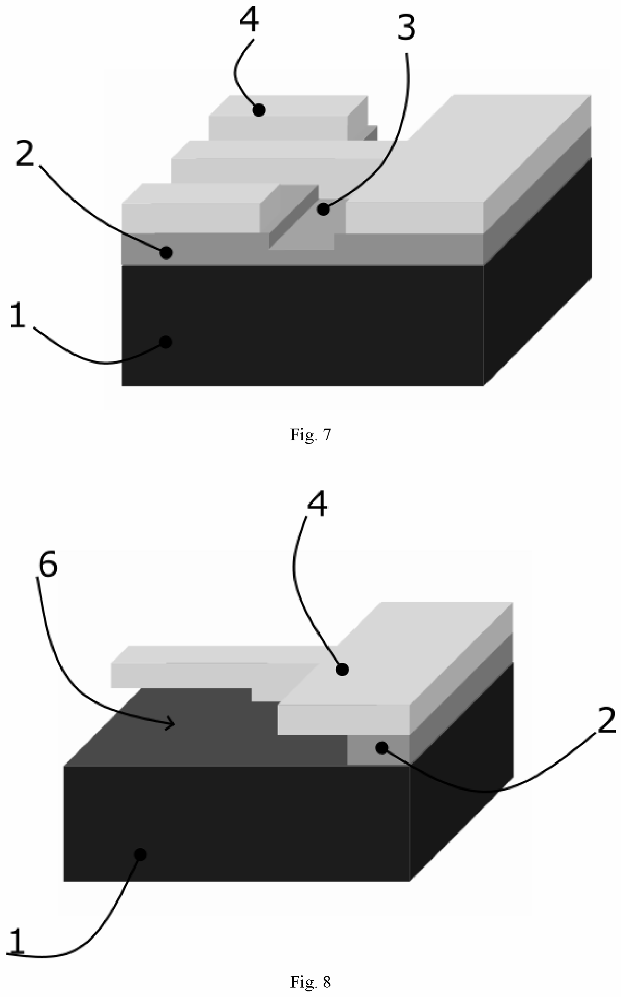

Fig. 7 shows a schematic product in an intermediate step of an alternative embodiment of a MEMS with a beam structure in the form of a wedge beam.
Fig. 8 shows a schematic final product of an alternative embodiment of a MEMS with a beam structure in the form of a wedge beam.

### Detailed description of embodiments

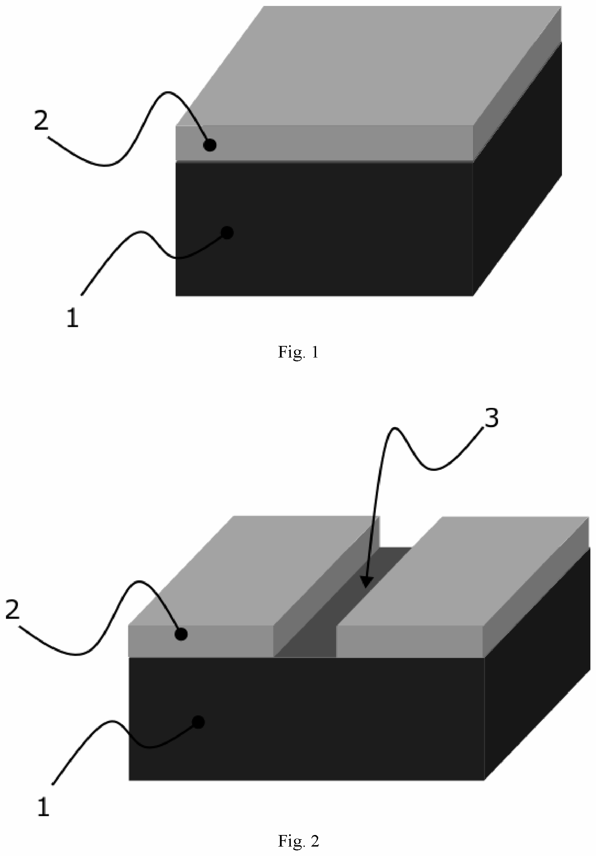

Referring to Fig. 1, a pure silicon substrate **1** is provided, for example a P-type silicon wafer with <100> orientation and a thickness of 500 µm. A layer of silicon dioxide (SiO₂) has been deposited onto this substrate **1** by chemical vapor deposition (CVD) with a thickness of 500 nm (maximum thickness up to 200 µm). Alternatively, silicon nitride (Si₃N₄) could be deposited . These layers constitute a sacrificial layer **2.**

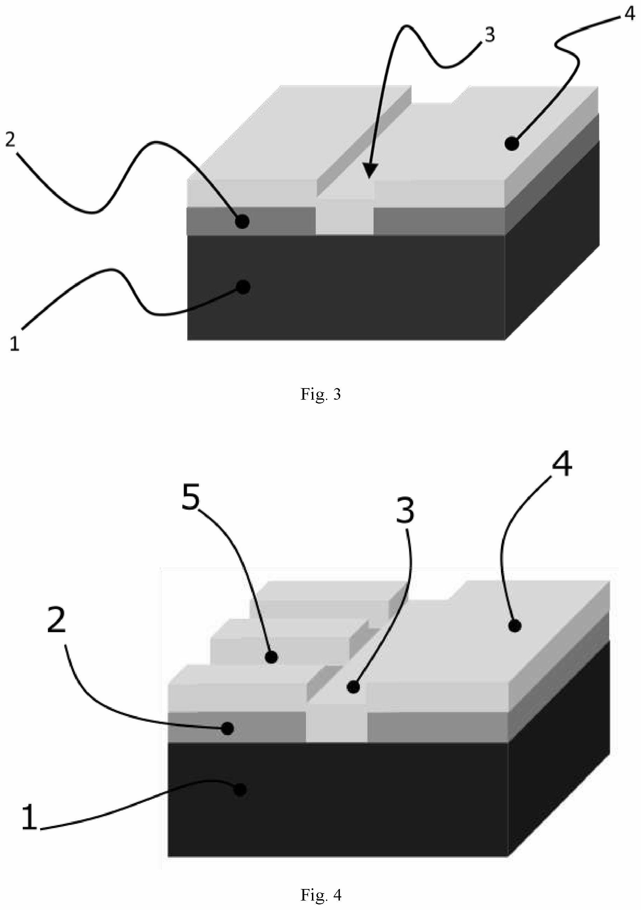

Referring to **Fig. 2****,** a photoresist is applied to the sacrificial layer **2** and a pattern is formed by photolithography to remove at least a portion of the sacrificial layer to support the desired beam structure. The exposed SiO₂ are then removed by wet etching (e.g., HF etching) or dry etching (e.g., RIE - reactive ion etching). Alternatively, laser-assisted machining (e.g., a 355 nm pulsed laser system) may be used to cut out precise exposed portions **3** in the sacrificial layer **2.** Referring to **Fig. 3****,** a diamond layer **4** is deposited on the prepared sacrificial layer **2** with cut-out exposed portions **3** for the beam structure by chemical vapor deposition (CVD) to a thickness of 200 µm. This process ensured that the diamond layer 4 filled the cut-out portions and bonded with the diamond layer **4** deposited on the surface of the sacrificial layer **2.** Referring to **Fig. 4****,** a portion of the diamond layer 4 is removed down to the sacrificial layer **2** using direct laser writing (e.g., a femtosecond laser with a wavelength of 800 nm). This step was performed through the entire thickness of the diamond layer, thereby creating a precise pattern of the beam structure **5.**

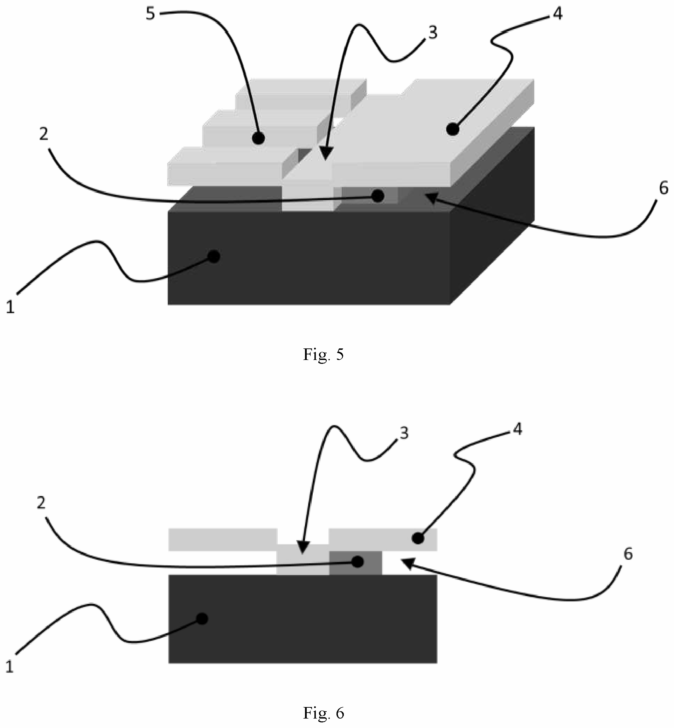

Referring to **Fig. 5****,** the sacrificial layer **2** is finally removed by wet etching (e.g. in HF solution). This step releases the beam structure **5** from the diamond layer **4,** thereby obtaining the final micro-electro-mechanical system (MEMS) with the precise beam structure **5.**

In an alternative embodiment, the substrate may be: sapphire , SiC , AlN , glass, with a thickness of 350 µm, chemical composition may be intrinsic or doped, orientation may be hexagonal or cubic, other properties may be: surface flatness (RMS less than 100 nm, planarity <10 µm. Preferred embodiments are particularly flat and smooth surfaces, as they are suitable for further lithographic processes and depositions (sacrificial layers or diamond layers).

In an alternative embodiment not forming part of the claimed invention, the sacrificial layer may be, for example: AlN, Cu, Al, amorphous Si, doped Si, with their thickness ranging from 150 nm to 200 µm, the chemical composition may be intrinsic or doped, the orientation may be crystalline or amorphous, other properties may be: temperature stable up to 400 °C and mechanically compact (stable, i.e. not crumbling /not crushing during transport or handling). Preferred embodiments are particularly temperature resistant and mechanically stable, since the deposition of diamond layers takes place at a temperature of >350 °C, and the sample is cleaned in an ultrasonic bath before deposition.

In another exemplary embodiment, the sacrificial layer can be deposited by various methods, such as plasma-enhanced chemical vapor deposition (PECVD), atomic layer deposition (ALD), physical vapor deposition (such as evaporation or sputtering ), sol-gel, hydrothermal chemical process, 3D printing, spin coating with subsequent curing.

The beam structure can be, for example, a beam with one support in the form of the letter T. Alternatively, a beam structure can be created representing a beam in the form of the letter H ( bridge ) attached on both sides.

To remove part or all of the sacrificial layer, wet etching with a solution of hydrofluoric acid, reactive ion etching in a gas mixture of fluorine and argon (for SiO ₂ or Si ₃ N ₄ ), reactive ion etching in a gas mixture of chlorine and argon, or methane and hydrogen (for AlN , Al, Cu) can be used.

The diamond layer can be deposited, for example, using microwave plasma linear antenna assisted chemical vapor deposition, HF CVD. The thickness of the diamond layer can be from 50 nm to 200 µm.

Removal of the diamond layer using laser machining can be carried out under the following parameters:
The diamond layer can be removed, for example, with a pulsed laser beam with a total pulse energy of 1.5 mJ and a central wavelength of 1064 nm with the following process parameters: beam sweep speed: 200-500 mm/s; pulse duration/width: 40-60 ns ; power: 40-60%; frequency: 20-30 kHz; number of loops: 1-200.

In an alternative embodiment not forming part of the claimed invention, the diamond layer can be removed by catalytic etching using a thin nickel etching mask that is deposited by evaporation. A photoresist is deposited on the nickel layer and the desired beam structure is patterned using photolithography. The nickel-covered parts of the diamond layer are then removed using hot water vapor.

In another embodiment, after providing a silicon substrate and depositing a sacrificial layer of silicon dioxide (SiO₂) or silicon nitride (Si₃N₄), in the range of 150 nm to 200 µm, a thin electrically conductive layer (e.g. Au, Ir, Pt, Cu, Al, doped Si) is deposited on the sacrificial layer using physical vapor deposition (PVD), such as evaporation or sputtering , with the thickness of the electrically conductive layer being in the order of tens of nanometers (e.g. 50 nm). A photoresist is deposited on the electrically conductive layer and a pattern of the desired beam structure is created using photolithography. The exposed portions of the sacrificial layer and the electrically conductive layer are then removed using wet etching (e.g. a combination of aqua regia for the gold conductive layer and HF for the sacrificial layer) or dry etching (e.g. RIE - reactive ion etching). Alternatively, laser-assisted machining (e.g., a pulsed laser system with a wavelength of 355 nm) can be used to cut precise parts in the sacrificial and electrically conductive layers. A diamond layer is then deposited onto the prepared sacrificial layer with the electrically conductive layer and the cut parts for the beam structure using chemical vapor deposition (CVD) to a thickness of 200 µm. This process ensures that the diamond layer fills the cut parts and bonds with the diamond layer deposited on the surface of the sacrificial layer.

In another embodiment, after providing a silicon substrate and depositing a sacrificial layer of silicon dioxide (SiO₂) or silicon nitride (Si₃N₄), in the range of 150 nm to 200 µm, a thin electrically conductive layer (e.g. Au, Ir, Pt, Cu, Al, doped Si) is deposited on the sacrificial layer using physical vapor deposition (PVD), such as evaporation or sputtering , with the thickness of the electrically conductive layer being in the order of tens of nanometers (e.g. 50 nm). A photoresist is deposited on the electrically conductive layer and the desired beam structure is patterned using photolithography. The exposed parts of the sacrificial layer and the electrically conductive layer are then removed using wet etching (e.g. a combination of aqua regia for gold and HF for the sacrificial layer), dry etching (e.g. RIE - reactive ion etching) or laser-assisted machining (e.g. a pulsed laser system with a wavelength of 355 nm), whereby the sacrificial layer is removed down to the substrate. A diamond layer is then deposited onto the prepared sacrificial layer with the electrically conductive layer and the cut-out parts for the beam structure using chemical vapor deposition (CVD) to a thickness of 200 µm. This process ensures that the diamond layer fills the cut-out parts and bonds with the diamond layer deposited on the surface of the sacrificial layer.

In another embodiment, after providing a silicon substrate and depositing a sacrificial layer of silicon dioxide (SiO₂) or silicon nitride (Si₃N₄), in the range of 150 nm to 200 µm, a thin electrically conductive layer (e.g. Au, Ir, Pt, Cu, Al, doped Si) is deposited on the sacrificial layer by physical vapor deposition (PVD), such as evaporation or sputtering , with the thickness of the electrically conductive layer being in the order of tens of nanometers (e.g. 50 nm). A photoresist is deposited on the electrically conductive layer and the desired beam structure is patterned using photolithography.

The exposed parts of the photoresist and the electrically conductive layer are then removed, followed by partial removal of the sacrificial layer. This step is performed using wet etching (e.g. a combination of aqua regia for gold and HF for the sacrificial layer), dry etching (e.g. RIE - reactive ion etching) or laser-assisted machining (e.g. a pulsed laser system with a wavelength of 355 nm), whereby the sacrificial layer is removed only in the cut areas, while remaining in the other areas **6.**

A diamond layer is then deposited onto the partially removed sacrificial layer with the electrically conductive layer and the cut-out parts for the beam structure using chemical vapor deposition (CVD) to a thickness of 200 µm. This process ensures that the diamond layer fills the cut-out parts and bonds with the diamond layer deposited on the surface of the partially removed sacrificial layer.

### Industrial applicability

The industrial applicability of the above-mentioned method of manufacturing a micro-electrical-mechanical system (MEMS) with a beam structure is considerable, especially in areas where highly accurate and reliable mechanical and electronic components are required. The technology of manufacturing MEMS using diamond layers and sacrificial layers, such as silicon dioxide or silicon nitride, finds wide application in the automotive industry for sensors and actuators , in telecommunications for microphone and accelerometer systems, in medicine for diagnostic and therapeutic devices, and in industrial automation for precision measurement and control systems. At least partial removal of the sacrificial layer and use of an interlayer of gold enables the production of high-quality and durable MEMS components that meet demanding performance and long-life requirements. The method according to the invention contributes to improving production efficiency and reducing costs, thereby ensuring a competitive advantage in the market and supporting technological progress in various industrial sectors. The introduction of laser machining into the process of manufacturing diamond microbeam structures speeds up and simplifies the technology by eliminating the need for photolithography processes.

## Claims

1. A method for manufacturing a micro-electrical-mechanical-system with a beam structure comprising the steps of:
• providing a substrate (1);
• depositing a sacrificial layer (2) of silicon dioxide or silicon nitride on the substrate (1);
• removing a portion in the sacrificial layer (2) by cutting or etching using laser-assisted machining, or wet etching, or dry etching;
• applying a diamond layer (4) to the sacrificial layer (2), wherein the diamond layer (4) is simultaneously applied to the location of the removed portion to form a part for supporting the beam structure, wherein the diamond layer (4) is applied at least to a height at which the diamond layer (4) on the sacrificial layer (2) and the part for supporting the beam structure (5) are connected;
• applying a further diamond layer at the location of the removed portion to mechanically strengthen the part for supporting the beam structure;
• applying another functional layer;
• removing at least a portion of the diamond layer (4) deposited on the sacrificial layer, wherein the removal of the portion of the diamond layer (4) is performed by direct laser removal through the entire thickness of the diamond down to the sacrificial layer (2); and
• removing the sacrificial layer (2) in its entire thickness by laser-assisted machining, or wet etching, or dry etching to the substrate (1) wherein between the steps of: applying the sacrificial layer (2) and the application of the diamond layer (4) an electrically conductive layer is applied to serve as an electrode of the beam structure.

2. The method according to claim 1 , **characterized in that** the sacrificial layer (2) is applied to a thickness of 150 nm to 200 µm.

3. The method according to any one of the preceding claims , **characterized in that** the diamond layer (4) is deposited on the sacrificial layer (2) using microwave plasma assisted chemical vapor deposition.

4. The method according to any one of the preceding claims, **characterized in that** the diamond layer (4) is deposited on the sacrificial layer (2) using a heated filament assisted chemical vapor deposition.

5. The method according to any one of the preceding claims, **characterized in that** the step of removing the sacrificial layer (2) comprises a step of wet etching using a hydrofluoric acid solution, or reactive ion etching in a gas mixture of fluorine and argon.

6. The method according to any one of the preceding claims, **characterized in that** the cutting or etching of the beam line in the sacrificial layer (2) by means of laser-assisted machining, or by wet etching, or by dry etching, removes the sacrificial layer (2) down to the substrate (1).

7. The method according to any one of the preceding claims, **characterized in that** the sacrificial layer (2) is only partially removed.

## Patentansprüche

1. Verfahren zur Herstellung eines mikroelektromechanischen Systems mit einer Balkenstruktur, umfassend die folgenden Schritte:
∘ Bereitstellen eines Substrats (1);
∘ Abscheiden einer Opferschicht (2) aus Siliziumdioxid oder Siliziumnitrid auf dem Substrat (1);
∘ Entfernen eines Abschnitts in der Opferschicht (2) durch Schneiden oder Ätzen mittels laserunterstützter Bearbeitung oder durch Nassätzen oder Trockenätzen;
∘ Aufbringen einer Diamantschicht (4) auf die Opferschicht (2), wobei die Diamantschicht (4) gleichzeitig auf die Stelle des entfernten Abschnitts aufgebracht wird, um einen Teil zur Abstützung der Balkenstruktur zu bilden, wobei die Diamantschicht (4) zumindest bis zu einer Höhe aufgebracht wird, bei der die Diamantschicht (4) auf der Opferschicht (2) und der Teil zur Abstützung der Balkenstruktur (5) miteinander verbunden sind;
∘ Aufbringen einer weiteren Diamantschicht an der Stelle des entfernten Abschnitts, um den Teil zur Abstützung der Balkenstruktur mechanisch zu verstärken;
∘ Aufbringen einer weiteren Funktionsschicht;
∘ Entfernen mindestens eines Abschnitts der auf der Opferschicht abgeschiedenen Diamantschicht (4), wobei das Entfernen des Abschnitts der Diamantschicht (4) durch direkten Laserabtrag über die gesamte Dicke des Diamanten bis zur Opferschicht (2) durchgeführt wird; und
∘ Entfernen der Opferschicht (2) in ihrer gesamten Dicke durch laserunterstützte Bearbeitung oder durch Nassätzen oder Trockenätzen bis zum Substrat (1), wobei zwischen dem Schritt des Aufbringens der Opferschicht (2) und dem Schritt des Aufbringens der Diamantschicht (4) eine elektrisch leitfähige Schicht aufgebracht wird, die als Elektrode der Balkenstruktur dient.

2. Verfahren nach Anspruch 1, **dadurch gekennzeichnet, dass** die Opferschicht (2) mit einer Dicke von 150 nm bis 200 µm aufgebracht wird.

3. Verfahren nach einem der vorhergehenden Ansprüche, **dadurch gekennzeichnet, dass** die Diamantschicht (4) mittels mikrowellenplasmaunterstützter chemischer Gasphasenabscheidung auf der Opferschicht (2) abgeschieden wird.

4. Verfahren nach einem der vorhergehenden Ansprüche, **dadurch gekennzeichnet, dass** die Diamantschicht (4) mittels heizfadenunterstützter chemischer Gasphasenabscheidung auf der Opferschicht (2) abgeschieden wird.

5. Verfahren nach einem der vorhergehenden Ansprüche, **dadurch gekennzeichnet, dass** der Schritt des Entfernens der Opferschicht (2) einen Schritt des Nassätzens unter Verwendung einer Flusssäurelösung oder des reaktiven Ionenätzens in einem Gasgemisch aus Fluor und Argon umfasst.

6. Verfahren nach einem der vorhergehenden Ansprüche, **dadurch gekennzeichnet, dass** durch das Schneiden oder Ätzen der Balkenlinie in der Opferschicht (2) mittels laserunterstützter Bearbeitung oder durch Nassätzen oder Trockenätzen die Opferschicht (2) bis zum Substrat (1) entfernt wird.

7. Verfahren nach einem der vorhergehenden Ansprüche, **dadurch gekennzeichnet, dass** die Opferschicht (2) nur teilweise entfernt wird.

## Revendications

1. Procédé de fabrication d'un système micro-électro-mécanique comportant une structure de poutre, comprenant les étapes consistant à :
∘ fournir un substrat (1) ;
∘ déposer une couche sacrificielle (2) de dioxyde de silicium ou de nitrure de silicium sur le substrat (1) ;
∘ retirer une partie de la couche sacrificielle (2) par découpe ou gravure au moyen d'un usinage assisté par laser, d'une gravure humide ou d'une gravure sèche ;
∘ appliquer une couche de diamant (4) sur la couche sacrificielle (2), la couche de diamant (4) étant simultanément appliquée à l'emplacement de la partie retirée afin de former une partie destinée à supporter la structure de poutre, la couche de diamant (4) étant appliquée au moins jusqu'à une hauteur à laquelle la couche de diamant (4) située sur la couche sacrificielle (2) et la partie destinée à supporter la structure de poutre (5) sont reliées ;
∘ appliquer une couche de diamant supplémentaire à l'emplacement de la partie retirée afin de renforcer mécaniquement la partie destinée à supporter la structure de poutre ;
∘ appliquer une autre couche fonctionnelle ;
∘ retirer au moins une partie de la couche de diamant (4) déposée sur la couche sacrificielle, le retrait de ladite partie de la couche de diamant (4) étant effectué par ablation laser directe sur toute l'épaisseur du diamant jusqu'à la couche sacrificielle (2) ; et
∘ retirer la couche sacrificielle (2) sur toute son épaisseur, jusqu'au substrat (1), au moyen d'un usinage assisté par laser, d'une gravure humide ou d'une gravure sèche, une couche électriquement conductrice étant appliquée, entre l'étape d'application de la couche sacrificielle (2) et l'étape d'application de la couche de diamant (4), afin de servir d'électrode de la structure de poutre.

2. Procédé selon la revendication 1, **caractérisé en ce que** la couche sacrificielle (2) est appliquée selon une épaisseur comprise entre 150 nm et 200 µm.

3. Procédé selon l'une quelconque des revendications précédentes, **caractérisé en ce que** la couche de diamant (4) est déposée sur la couche sacrificielle (2) par dépôt chimique en phase vapeur assisté par plasma micro-ondes.

4. Procédé selon l'une quelconque des revendications précédentes, **caractérisé en ce que** la couche de diamant (4) est déposée sur la couche sacrificielle (2) par dépôt chimique en phase vapeur assisté par filament chauffé.

5. Procédé selon l'une quelconque des revendications précédentes, **caractérisé en ce que** l'étape de retrait de la couche sacrificielle (2) comprend une étape de gravure humide utilisant une solution d'acide fluorhydrique ou une étape de gravure ionique réactive dans un mélange gazeux de fluor et d'argon.

6. Procédé selon l'une quelconque des revendications précédentes, **caractérisé en ce que** la découpe ou la gravure de la ligne de poutre dans la couche sacrificielle (2), au moyen d'un usinage assisté par laser, d'une gravure humide ou d'une gravure sèche, retire la couche sacrificielle (2) jusqu'au substrat (1).

7. Procédé selon l'une quelconque des revendications précédentes, **caractérisé en ce que** la couche sacrificielle (2) n'est retirée que partiellement.
